(19) Europäisches Patentamt
European Patent Office
Office européen des brevets

(11) Veröffentlichungsnummer: **0 143 201**
**B1**

(12) # EUROPÄISCHE PATENTSCHRIFT

(45) Veröffentlichungstag der Patentschrift: **12.08.87**

(51) Int. Cl.[4]: **C 08 F 2/50,** G 03 C 1/68

(21) Anmeldenummer: **84110285.8**

(22) Anmeldetag: **29.08.84**

(54) **Photopolymerisierbare Mischungen mit speziellen Diaminobenzophenon-Verbindungen.**

(30) Priorität: **01.09.83 DE 3331474**

(43) Veröffentlichungstag der Anmeldung: **05.06.85 Patentblatt 85/23**

(45) Bekanntmachung des Hinweises auf die Patenterteilung: **12.08.87 Patentblatt 87/33**

(84) Benannte Vertragsstaaten: **BE CH DE FR GB IT LI**

(56) Entgegenhaltungen: **DE-A-2 730 897**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft, Carl-Bosch- Strasse 38, D-6700 Ludwigshafen (DE)**

(72) Erfinder: **Holoch, Klaus, Dr., Virchowstrasse 4, D-6712 Bobenheim- Roxheim (DE)**
Erfinder: **Henne, Andreas, Dr., Adolf- Kolping-Strasse 137 a, D-6730 Neustadt (DE)**
Erfinder: **Lechtken, Peter, Dr., Ludwigshafener Strasse 6 b, D-6710 Frankenthal (DE)**

**EP 0 143 201 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

**Beschreibung**

Die Erfindung betrifft photopolymerisierbare Mischungen mit mindestens einer photopolymerisierbaren olefinisch ungesättigten Verbindung sowie gegebenenfalls einem polymeren Bindemittel, die spezielle Diaminobenzophenon-Verbindungen als Sensibilisator enthalten sowie die Verwendung solcher Mischungen für maskenbildende Schichten, für Kopierfilme und mehrschichtige Aufzeichnungsmaterialien.

Photopolymerisierbare Mischungen mit olefinisch ungesättigten Verbindungen, gegebenenfalls polymeren Bindemitteln und Photoinitiatorsystemen, die Diaminobenzophenon-Verbindungen als Sensibilisatoren enthalten, sind bekannt. So ist das synergistische System aus 4,4'-Bis(dimethylamino)-ben-zophenon (Michlers Keton) und Benzophenon aufgrund seiner hohen Lichtabsorption, Radikalbildungsrate und seines neutralen Verhaltens auf die Dunkellagerstabilität ein sehr wirksames Photoinitiatorsystem besonders für dünne photopolymerisierbare Schichten. Dabei wirkt das hochabsorbierende Michlers Keton als Sensibilisator für das im gleichen aktinischen Wellenbereich wenig oder niedrig lichtabsorbierende Benzophenon. Besonders bei der Herstellung von Kopier- und Maskenfilmen ist die Verwendung von Photoinitiatorsystemen in recht hohen Konzentrationen, z. B. von Michlers Keton in einer Konzentration von über 6 Gew.% gewünscht, um die gehärteten Maskenfilmteile bei einer anschließenden Belichtung UV-polymerisierender Schichten unter dem Maskenfilm für UV-Licht undurchlässig zu machen.

Die Verwendung von höheren Konzentrationen von Michlers Keton in Fotoinitiatorsystemen in dünnen photopolymierisierbaren Schichten führt jedoch häufig zu Schwierigkeiten, da Michlers Keton in seinen toxischen Eigenschaften, wegen seiner begrenzten Löslichkeit in vielen organischen Lösungsmitteln und seiner begrenzten Verträglichkeit selbst mit manchen polaren Bindemitteln für photopolymerisierbare Mischungen nicht befriedigt. So kommt es z. B. bei höheren Konzentrationen an Michlers Keton in photopolymerisierbaren Mischungen zur Trübung gelagerter Schichten, während Benzophenon problemlos auch in größerer Konzentration verarbeitet werden kann.

Aus der DE-OS 2 730 897 ist bekannt, Derivate von Michlers Keton zu verwenden, bei denen die Methylgruppen in Michlers Keton z. B. durch Hydroxyethyl-, Hydroxyethoxyethyl-, Hydroxypropyl- oder Hydroxypropoxypropyl-Gruppen ersetzt sind. Diese Verbindungen weisen zwar bereits eine verbesserte Verträglichkeit auf, befriedigen jedoch noch nicht in allen Fällen.

Der vorliegenden Erfindung lag die Aufgabe zugrunde, Diaminobenzophenon-Verbindungen als Photosensibilisatoren für photopolymerisierbare Mischungen zu finden, die bei guter Wirkung als Photosensibilisator eine verbesserte Verträglichkeit bei längerer Lagerung aufweisen.

Es wurde nun gefunden, daß photopolymerisierbare Mischungen auf der Basis mindestens einer photopolymerisierbaren olefinisch ungesättigten Verbindung sowie gegebenenfalls einem polymeren Bindemittel enthaltend mindestens eine Diaminobenzophenon-Verbindung als Photosensibilisator die gewünschten Eigenschaften aufweisen, wenn sie eine Diaminobenzophenon-Verbindung der Formel (I)

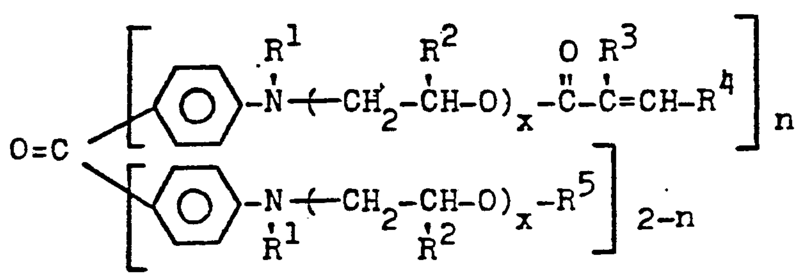

(I)

enthalten, worin
$R^1$ = H, $C_1$- bis $C_4$-Alkyl oder Phenyl,
$R^2$ = H oder $C_1$- bis $C_2$-Alkyl,
$R^3$ = H oder $C_1$- bis $C_4$-Alkyl, vorzugsweise H oder Methyl,
$R^4$ = H, $C_1$- bis $C_4$-Alkyl, $CO_2R^7$ oder -$CONHR^8$,
$R^5$ = H, -COR oder -$CONHR^8$,
$R^6$ = $C_1$- bis $C_8$-Alkyl oder Phenyl,
$R^7$ = H oder $R^6$,
$R^8$ = aliphatischer oder aromatischer Rest mit 2 bis 22 C-Atomen,
X = 1, 2 oder 3,
$0{,}1 \leqslant n \leqslant 2$
bedeuten.

Die erfindungsgemäß verwendeten Diaminobenzophenon-Verbindungen der Formel (I) stellen Reaktionsprodukte von alkoxylierten Diaminbenzophenomen mit α,β-olefinisch ungesättigten Carbonsäuren, insbesondere Maleinsäure, Acryl- oder Methacrylsäure, oder ihren Derivaten dar, die gegebemenfalls auch mit Alkanolen, Carbonsäuren und/oder Isocyanaten verestert bzw. zum Amid umgesetzt wurden. Bevorzugt sind es

Umsetzungsprodukte von Bis-(N-hydroxyethylamino)benzophenonen mit Maleinsäureanhydrid oder den anhydriden oder Chloriden der Acryl- oder Methacrylsäure, wobei die N-Hydroxyalkylgruppen teilweise oder ganz verestert werden, wobei noch eine Umsetzung freier Hydroxylgruppen, freier Carboxylgruppen mit Alkoholen Carbonsäuren oder deren Derivaten oder Isocyanaten erfolgen kann.

Die folgenden Gleichungen geben bevorzugte Beispiele für die Veresterung wieder:

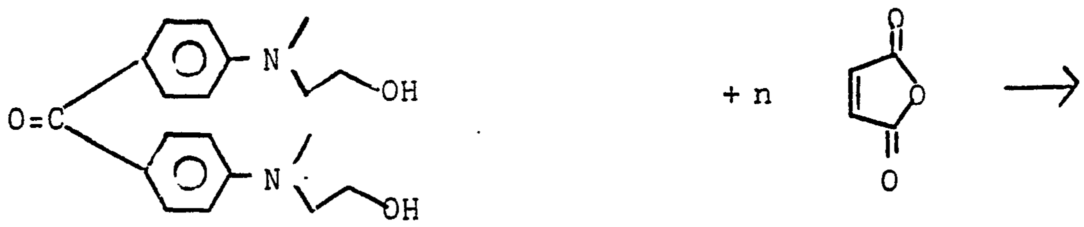

(II) (III)

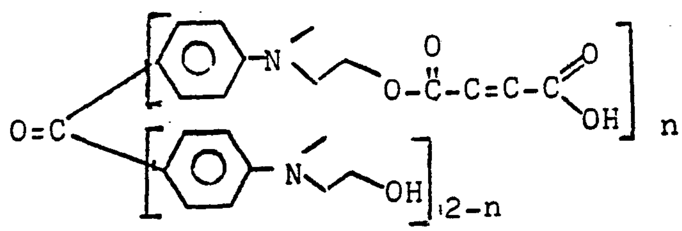

(IV) $0{,}1 \leq n \leq 2$

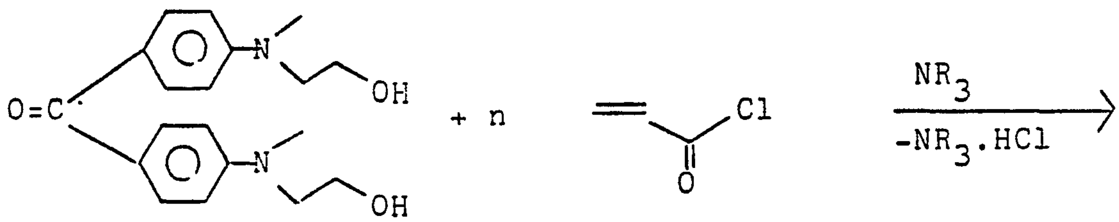


(II) (V)

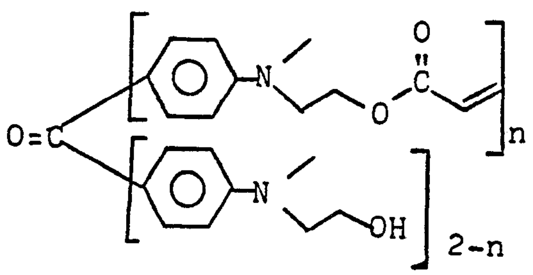

(VI) $0{,}1 \leq n \leq 2$

II: 4,4'-Bis(N-methyl-N-β-hydroxyethyl-amino)-benzophenon (beschrieben in DE-OS 27 22 421)

III: Maleinsäureanhydrid

V: Acrylsäurechlorid

Die freie Carboxylgruppe der Verbindung der Formel (IV) sowie die freien Hydroxylgruppen der Verbindungen der Formeln (IV) oder (VI) lassen sich auch z. B. verestern oder mit Isocyanaten zu Amiden bzw. Urethanen umsetzen.

Von den Umsetzungsprodukten der vorstehenden Art haben sich die Kondensationsprodukte von 1,1 bis 1,4 und insbesondere etwa 1,3 Molen Maleinsäureanhydrid mit 1 Mol Bis(N-alkyl-N-β-hydroxyethylamino)-benzophenon, die bei ca. 110 bis 140°C bevorzugt in Abwesenheit von Lösungsmittel umgesetzt wurden, besonders bewährt.

Die erfindungsgemäß verwendeten Diaminobenzophenon-Verbindungen erlauben aufgrund ihrer guten Verträglichkeit mit üblichen photopolymerisierbaren Mischungen einen Einsatz auch in höheren Konzentrationen, z. B. 10 bis 15 Gew.%, bezogen auf den Feststoffgehalt der Mischungen, ohne daß selbst bei wochenlanger, ja monatelanger Lagerung bei Raumtemperatur eine Ausscheidung bzw. ein Auskristallisieren der Diaminobenzophenon-Verbindung erfolgt.

Von besonderem Vorteil ist es, in den erfindungsgemäßen Mschungen neben den Diaminobenzophenon-Verbindungen einen weiteren bekannten Photoaktivator mitzuverwenden, wie Benzoin, Benzoinether, Anthrachinon, Benzil, Benzilmonoalkylketale, Fluorenon, Fluoren, Diacetyl und insbesondere Benzophenon oder ein im Bereich von 300 bis 380 nm niedrig absorbierendes Benzophenonderivat, wie solchen mit einem Extinktionskoeffizienten $\varepsilon_{360\ nm} < 200$, wobei die für die Kombination mit Michlers Keton bekannten molaren Verhältnisse und Mengen angewandt werden können.

Die erfindungsgemäß verwendeten Diaminobenzophenon-Verbindungen verbessern überraschenderweise auch die Verträglichkeit von Michlers Keton, so daβ es sich zur Erzielung einer hohen optischen Dichte bei gleichzeitig hoher Lichtempfindlichkeiten bei Maskenfilmen als recht vorteilhaft erwiesen hat, als Photoinitiator-System eine Kombination einer erfindungsgemäβ verwendeten Diaminobenzophenon-Verbindung der Formel (I) mit insbesondere etwa 20 bis 50 Gew.% an Michlers Keton, bezogen auf die Menge der Diaminophenon-Verbindung der Formel (I) und bevorzugt mit etwa 1/3 bis 2/3 der Summe der Mengen an Michlers Keton und Diaminobenzophenon-Verbindung der Formel (I) an Benzophenon zu verwenden.

Die erfindungsgemäßen photopolymerisierbaren Mischungen enthalten in bekannter Weise photopolymerisierbare olefinisch ungesättigte Verbindungen wie Monomere und/oder Oligomere, die zumindest teilweise mehrfach olefinisch ungesättigt sind und in Gegenwart von Photoinitiator-Systemen sich rasch durch UV-Bestrahlung in in Entwicklern schwer- oder unlösliche Produkte überführen lassen. Dabei eignen sich die photopolymerisierbaren olefinisch ungesättigten Verbindungen, die für mit UV-Licht vernetzbare Bindemittel und für Photopolymer-Druckplatten an sich bekannt sind, wobei sich Art und Menge nach dem Anwendungszweck der Mischungen richtet sowie nach dem gegebenenfalls mitverwendeten polymeren Bindemittel, mit dem sie verträglich sein sollen.

Geeignete olefinisch ungesättigte Verbindungen sind Di- und Polyacrylate und -methacrylate, wie sie durch Veresterung von Diolen oder Polyolen mit Acrylsäure oder Methacrylsäure hergestellt werden können, wie die Di- und Tri(meth)acrylate von Ethylenglykol, Diethylenglykol, Triethylenglykol, Polyethylenglykol mit einem Molekulargewicht bis etwa 500, 1,2-Propan-diol, 1,3-Propandiol, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z. B. Ethylenglykol- oder Di-, Tri- oder Tetraethylenglykolmonoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder (Meth)acrylate von Monoalkoholen mit 1 bis 6 C-Atomen.

Sehr bewährt haben sich erfindungsgemäße Mischungen, die polare Monomere und/oder polare polymere Bindemittel enthalten, wie Urethanacrylate oder Expoxidacrylate. Bezüglich geeigneter Bindemittelkomponenten sowie der Anwendung der erfindungsgemäßen Systeme sei auf die DT-OS 1 522 359, 2 200 478, 2 358 948, 2 441 148 verwiesen, wobei die erfindungsgemäß verwendeten Diaminobenzophenon-Verbindungen an die Stelle des dort beschriebenen Michlers Keton treten können.

Geeeignete polymere Bindemittelkomponenten sind z. B. Polyurethane, ungesättigte Polyester, Polyesterurethane sowie carboxylgruppenhaltige Polymere wie Copolynere von Acrylsäure, Methacrylsäure und insbesondere Maleinsäure oder deren Derivaten.

In bekannter Weise können die erfindungsgemäßen photopolymerisierbaren Mischungen auch übliche Zusätze enthalten, wie thermische Polymerisationsinhibitoren, Farbstoffe, Weichmacher usw.

Besondere Bedeutung kommt der größeren Löslichkeit der erfindungsgemäß angewendeten Diaminobenzophenone bei ihrer Verwendung für eine ausreichende Härtung hoch pigmentierter photopolymerisierbarer Systeme zu, insbesondere bei Verwendung hochabsorbierender Pigmente, z. B. in UVhärtenden Druckfarben.

Die erfindungsgemäßem photopolymerisierbaren Mischungen eignen sich besonders in Schichtdicken kleiner als 10 µm für UV-härtende Druckfarben, aber auch für Offsetdruckplattenbeschichtungen und als Photoresist-Material. Besonders bewährt haben sie sich für maskenbildende Schichten, für Kopierfilme und mehrschichtige Aufzeichnungsmaterialien. So ist es möglich, auf übliche UV-vernetzbare Photopolymerdruckplatten einen hochempfindlichen Maskenfilm mit hohem Photosensibilisator- und -initiatorgehalt mit einer dünnen Polymerfolie als Träger aufzukaschieren, der bildmäßig durch eine Vorlage oder mit UV-Laser mit einer Belichtungszeit von wenigen Sekunden belichtet werden kann, ohne daß dabei eine Photovernetzung der darunter befindlichen photovernetzbaren reliefbildenden Schicht der Photopolymerdruckplatte eintritt. Nach Entwicklung des Maskenfilms mit z. B. wäßrigem Alkali kann dann durch die erzeugte Maskenschicht die Photopolynerdruckplatte vollflächig mit UV-Strahlung belichtet und

nach Abziehen des Maskenfilms in üblicher Weise zur Reliefform bzw. Reliefdruckform entwickelt werden. Zweckmäßig tragen die Kopierfilme bzw. aufkaschierbaren Maskenfilme über der photopolymerisierbaren Schicht auf der transparenten Trägerfolie einen vor der Belichtung abziehbaren Deckfilm wie einen mit z. B. einem Polyamidsubstrat versehenen Polyesterfilm.

Die in den nachstehenden Beispielen genannten Teile und Prozente beziehen sich, soweit nicht anders angegeben, auf das Gewicht. Volumenteile verhalten sich zu Gewichtsteilen wie Liter zu Kilogramm.

**Beispiel 1**

1.1 Herstellung eines Reaktionsproduktes aus 4,4'-Bis(N-methyl-N-β-hydroxyethylamino)-benzophenon und Maleinsäureanhydrid

164 Teile 4,4'-Bis(N-methyl-N-β-hydroxyethylamino)-benzophenon und 63,7 Teile Maleinsäureanhydrid werden in einem Reaktionsgefäß gemischt und in Abwesenheit von Lösungsmittel 10 Minuten bei 130°C gerührt. Das viskose Reaktionsprodukt wird auf eine Aluminiumfolie gegossen und die glasartig harte Masse nach dem Erstarren zerkleinert.

Analyse:

ber. (für $C_{24,2}H_{26,6}N_2O_{6,9}$) C: 63,7 % H: 5,8 % N: 6,1 %

gef. C: 62,9 % H: 5,9 % N: 6,0 %

1.2 Herstellung einer maskenbildenden Schicht

Auf eine durch Corona-Entladung vorbehandelte 125 µm starke Polyethylenterephthalatfolie, die zuerst mit einer 2 bis 3 µm starken Polyamid-Substratschicht, dann mit einer 10 µm starken Schicht eines Polyvinylalkohols (Verseifungsgrad 88 Mol%, Viskosität 18 mPa.s versehen wurde, wird eine gefilterte Lösung von 180 Teilen eines Copolymerisates aus 40 % n-Butylacrylat, 35 % Styrol und 25 % Methacrylsäure, 120 Teilen 1,1,1-Trimethylolpropan-triacrylat, 48 Teilen des gemäß 1.1 hergestellten Reaktionsproduktes, 12 Teilen Michlers Keton, 30 Teilen Benzophenon, 6,3 Teilen eines Nitrosamins in 900 Teilen Methylethylketon, der 50 Teile einer gesättigten Lösung des Farbstoffs 3-Amino-5-nitro-2,1-benzisothiazol → N-(2-Methoxycarbonylethyl)-N-ethylanilin in Methylethylketon zugesetzt wurden, so schichtförmig aufgegossen, daß eine 6 µm starke Schicht nach dem Trocknen entsteht. Auf diese wird eine 12 µm starke transparente Polyethylenterephthalatfolie aufkaschiert. Die photopolymerisierbare Schicht kann monatelang bei Raumtemperatur gelagert werden, ohne daß eine Auskristallisation des Photosensibilisators auftritt.

1.3 Verwendung der maskenbildenden Schicht bei der Herstellung einer Reliefdruckplatte

Die gemäß 1.2 hergestellte maskenbildende Schicht wird mit der 12 µm starke Polyesterfolie nach unten auf eine handelsübliche Hochdruckphotopolymerplatte, die durch Bestrahlen mit UV-Licht photovernetzt werden kann, aufkaschiert. Zur Herstellung des Druckklischees wird die 125 µm starke Polyesterfolie mit dem Polyamidsubstrat abgezogen und die photopolymerisierbare M schung des Maskenfilms bildmäßig etwa 3 Sekunden lang belichtet. Nach Abwaschen der Polyvinylalkoholschicht werden die unbelichteten Anteile der photopolymerisierbaren Schicht des Maskenfilms mit wäßrigem Alkali (pH = 11) ausgewaschen, und danach wird durch den resultierenden Maskenfilm die Hochdruckphotopolymerplatte 3 bis 5 Minuten vollflächig belichtet. Nach dem anschließenden Abziehen der Maske kann die Hochdruckphotopolymerplatte in üblicher Art entwickelt und zur Reliefdruckform weiterverarbeitet werden.

**Beispiel 2**

2.1 Herstellung eines Reaktionsproduktes aus 4,4'-Bis(N-methyl-N-β-hydroxyethylamino)-benzophenon und Acrylsäurechlorid

130,4 Teile 4,4'-Bis(N-methyl-N-β-hydroxyethylamino)-benzophenon, 0,2 Teile Hydrochinon und 91 Teile Triethylamin werden in einem Reaktionsgefäß in 300 Volumenteilen Dimethylformamid gelöst. In die auf 0 bis 5°C gekühlte Lösung werden unter Rühren langsam portionsweise 58 Teile Acrylsäurechlorid zugegeben und dann 15 Stunden bei 25°C nachgerührt. Nach Zugabe von 800 Volumenteilen Methylenchlorid wird die Lösung in 1000 Volumenteile Wasser eingerührt, die untere Phase abgetrennt und noch zweimal mit je 500 Volumenteilen Wasser gewaschen. Dann wird mit 600 Volumenteilen 5 %iger wäßriger Natriumcarbonatlösung gewaschen. Nach Zusatz von 0,2 Teilen Hydrochinon wird das Lösungsmittel im Wasserstrahlvakuum abgezogen und der Rückstand im Vakuum von 0,1 0,133 mbar bei 30°C getrocknet. Es verbleiben 115,6 Teile eines zähflüssigen Reaktionsproduktes, das nach der NMR-Analyse die Verbindung der Formel (VI) mit n etwa 1,2 darstellt.

NMR-Analyse (Lösungsmittel $CDCl_3$): Signale bei 3,06 ppm (100 %); 3,57 ppm (breit, 22,6 %); 3,62 ppm (breit, 48 %); 3,8 ppm (breit, 22,6 %); 4,37 ppm (breit, 48 %); 5,84 (Dublett, 19,4 %); 6,10 ppm (Multiplett, 19,4 %); 6,38 ppm (Dublett, 19,4 %); 6,65 bis 6,8 ppm (Multiplett, 74,2 %); 7,6 bis 7,8 ppm (Multiplett, 74,2 %).

2.2 Herstellung einer maskenbildenden Schicht

Es wird wie in Beispiel 1.2 verfahren, jedoch werden anstelle von 48 Teilen des gemäß 1.1 hergestellten Reaktionsproduktes und 12 Teilen Michlers Keton 40 Teile des gemäß 2.1 hergestellten Reaktionsproduktes

verwendet. Die resultierenden Schichten sind ohne Auskristallisation viele Wochen bei Raumtemperatur lagerfähig.

## Patentansprüche

1. Photopolymerisierbare Mischung auf der Basis mindestens einer photopolymerisierbaren olefinisch ungesättigten Verbindung sowie gegebenenfalls eines polymeren Bindemittels, enthaltend mindestens eine Diaminobenzophenon-Verbindung als Photosensibilisator, dadurch gekennzeichnet, daß sie eine Diaminobenzophenon-Verbindung der Formel (I)

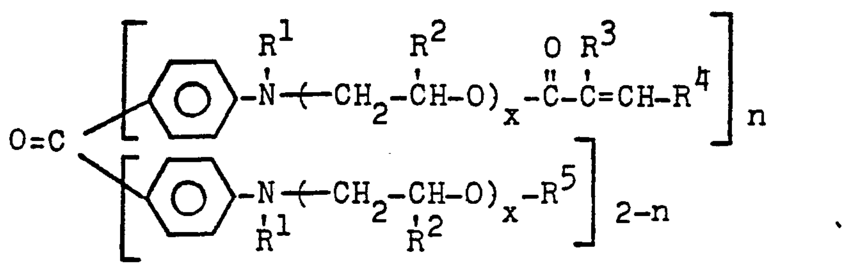

(I)

enthält, worin bedeuten:
$R^1$ = H, $C_1$ - bis $C_4$-Alkyl oder Phenyl,
$R^2$ = H oder $C_1$ - bis $C_2$ -Alkyl,
$R^3$ = H oder $C_1$ - bis $C_4$-Alkyl,
$R^4$ = H, Cl- bis $C_4$-Alkyl, -$CO_2R^7$ oder -$CONHR^8$,
$R^5$ = H, -$COR^6$ oder -$CONHR^8$,
$R^6$ = $C_1$- bis $C_8$-Alkyl oder Phenyl,
$R^7$ = H oder $R^6$
$R^8$ = aliphatischer oder aromatischer Rest mit 2 bis 22 C-Atomen,
x = 1, 2 oder 3,
$0{,}1 \leqslant n \leqslant 2$.

2. Photopolymerisierbare Mischung gemäß Anspruch 1, dadurch gekennzeichnet, daß sie eine Diaminobenzophenon-Verbindung der Formel (I) enthält, worin
$R^3$ = H oder Methyl,
$R^4$ = H oder -$CO_2R^7$ und
$R^5$ = H bedeuten.

3. Photopolymerisierbare Mischung gemäß Anspruch 1 oder 2, dadurch gekennzeichnet, daß sie zusätzlich zur Diaminobenzophenon-Verbindung der Formel (I) Michlers Keton enthält.

4. Photopolymerisierbare Mischung gemäß einem der Ansprüche 1 bis 3, dadurch gekennzeichnet, daß sie zusätzlich zu den Diaminobenzophenon-Verbindungen der Formel (I) Benzophenon oder ein im Bereich von 300 bis 380 nm niedrig absorbierendes Benzophenonderivat enthält.

5. Verwendung von photopolymerisierbaren Mischungen gemäß einem der Ansprüche 1 bis 4 für maskenbildende Schichten, für Kopierfilme und mehrschichtige Aufzeichnungsmaterialien.

## Claims

1. A photopolymerizable mixture, based on at least one photopolymerizable olefinically unsaturated compound and, if desired, a polymeric binder, containing at least one diaminobenzophenone compound as photosensitizer, wherein the diaminobenzophenone compound used is of the formula (I)

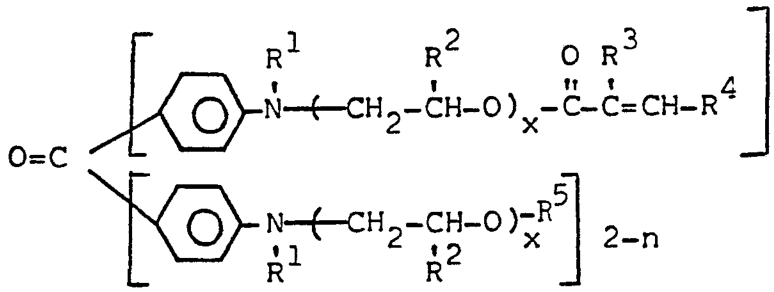 (I),

where
$R^1$ = H, $C_1$-$C_4$-alkyl or phenyl,
$R^2$ = H or $C_1$- or $C_2$-alkyl,
$R^3$ = H or $C_1$-$C_4$-alkyl
$R^4$ = H, $C_1$-$C_4$-alkyl -$CO_2R^7$ or -$CONHR^8$,
$R^5$ = H, -$COR^6$ or -$CONHR^8$,
$R^6$ = $C_1$-$C_8$-alkyl or phenyl,
$R^7$ = H or $R^6$,
$R^8$ = an aliphatic or aromatic radical of 2 to 22 carbon atoms,
x = 1, 2 or 3, and
$0.1 \leqslant n \leqslant 2$.

2. A photopolymerizable mixture as claimed in claim 1, containing a diaminobenzophenone compound of the formula (I),
where
$R^3$ = H or methyl,
$R^4$ = H or -$CO_2R^7$, and
$R^5$ = H.

3. A photopolymerizable mixture as claimed in claim 1 or 2, containing Michler's ketone in addition to the diaminobenzophenone compound of the formula (I).

4. A photopolymerizable mixture as claimed in any of claims 1 to 3, containing benzophenone, or a benzophenone derivative which exhibits low absorption in the range from 300 to 380 nm, in addition to the diaminobenzophenone compound of the formula (I).

5. The use of a photopolymerizable mixture as claimed in any of claims 1 to 4 for mask-forming layers, copying films and multi-layer recording materials.

**Revendications**

1. Mélange photopolymérisable basé sur au moins un composé à insaturation oléfinique photopolymérisable, ainsi qu'éventuellement sur un liant polymère, contenant comme photosensibilisateur au moins un composé diaminobenzophénonique, caractérisé en ce que le composé diaminobenzophénonique est un composé de la formule (I)

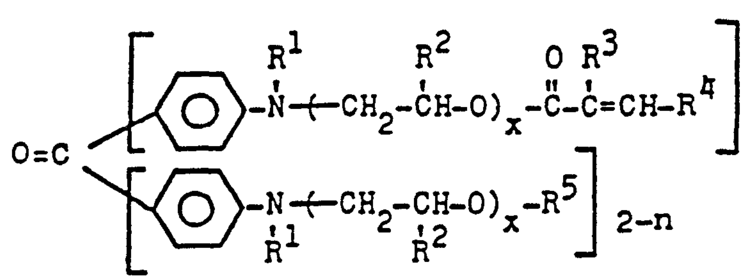 (I)

dans laquelle
$R^1$ = H, alkyle en $C_1$ à $C_4$ ou phényle,
$R^2$ = H ou alkyle en $C_1$ ou $C_2$,
$R^3$ = H ou alkyle en $C_1$ à $C_4$

$R^4$ = H, alkyle en $C_1$ à $C_4$, $-CO_2R^7$ ou -CONHR$^8$,
$R^5$ = H, $-COR^6$ ou -CONHR$^8$,
$R^6$ = alkyle en $C_1$ à $C_8$ ou phényle,
$R^7$ = H ou $R^6$,
$R^8$ = reste aliphatique ou aromatique en $C_2$ à $C_{22}$
x = 1, 2 ou 3 et $0,1 \leqslant n \leqslant 2$.

2. Mélange photopolymérisable suivant la revendication 1, caractérisé en ce qu'il contient un composé diamino-benzophénonique de la formule (I) avec
$R^3$ = H ou méthyle,
$R^4$ = H ou $-CO_2R_7$ et
$R^5$ = H.

3. Mélange photopolymérisable suivant la revendication 1 ou la revendication 2, caractérisé en ce qu'il contient, à côté du composé diamino-benzophénonique, de la cétone de Michler.

4. Mélange photopolymérisable suivant l'une des revendications 1 à 3, caractérisé en ce qu'il contient, à côté des composés diamino-benzophénoniques de la formule (I), de la benzophénone ou un dérivé de la benzophénone à faible pouvoir d'absorption dans la gamme de 300 à 380 nm.

5. Utilisation de mélanges photopolymérisables suivant l'une des revendications 1 à 4 pour la production de couches de masquage, de films à copier et de matériaux d'enregistrement stratifiés.